(19) Europäisches Patentamt
European Patent Office
Office européen des brevets

(11) **EP 4 394 406 A1**

(12) **EUROPEAN PATENT APPLICATION**
published in accordance with Art. 153(4) EPC

(43) Date of publication:
**03.07.2024 Bulletin 2024/27**

(21) Application number: **22902677.8**

(22) Date of filing: **06.04.2022**

(51) International Patent Classification (IPC):
***G01R 31/382*** (2019.01)

(52) Cooperative Patent Classification (CPC):
**Y02E 60/10**

(86) International application number:
**PCT/CN2022/085270**

(87) International publication number:
**WO 2023/103235 (15.06.2023 Gazette 2023/24)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.12.2021 CN 202111491986**

(71) Applicant: **Svolt Energy Technology (Wuxi) co.,
Ltd.
Jiangsu 214105 (CN)**

(72) Inventors:
• **WANG, Jiaojiao**
  **Wuxi, Jiangsu 214105 (CN)**
• **YU, Ao**
  **Wuxi, Jiangsu 214105 (CN)**
• **LI, Shuxian**
  **Wuxi, Jiangsu 214105 (CN)**
• **ZHANG, Yaojun**
  **Wuxi, Jiangsu 214105 (CN)**
• **HE, Jianchao**
  **Wuxi, Jiangsu 214105 (CN)**
• **GAO, Fei**
  **Wuxi, Jiangsu 214105 (CN)**
• **YANG, Hongxin**
  **Wuxi, Jiangsu 214105 (CN)**

(74) Representative: **Groth & Co. KB
P.O. Box 6107
102 32 Stockholm (SE)**

(54) **METHOD AND APPARATUS FOR ASSESSING INTERNAL TEMPERATURE DISTRIBUTION OF BATTERY CELL, AND DEVICE AND STORAGE MEDIUM**

(57) A method and an apparatus for assessing internal temperature distribution of a battery cell, and the method comprises: acquiring lithium content at different positions on a negative electrode plate of a target battery cell and a corresponding test environment temperature (S101); determining lithium intercalation reaction rate ratios at different positions on the basis of the lithium content at different positions on the negative electrode plate (S102); calculating temperature values at different positions on the negative electrode plate respectively on the basis of the lithium intercalation reaction rate ratios at different positions on the negative electrode plate and the test environment temperature (S103); determining an internal temperature distribution assessment result of the target battery cell on the basis of the temperature values at different positions on the negative electrode plate (S104). Therefore, temperature gradients at different positions can be calculated by measuring the lithium content on a lithium-intercalated negative electrode plate, so that the internal temperature distribution assessment result of the battery cell can be obtained. The method has the advantages of a wide application range, a simple, accurate and efficient test and calculation way, so as to facilitate mastering a change in an internal temperature gradient of the battery cell, thereby providing accurate temperature parameters for battery cell design, and providing a theoretical basis for improving the cyclic stability, safety and reliability of the battery cell.

EP 4 394 406 A1

S101

acquiring lithium content at different positions on a negative electrode plate of a target battery cell and a corresponding test environment temperature

S102

determining lithium intercalation reaction rate ratios at different positions on the basis of the lithium content at different positions on the negative electrode plate

S103

calculating temperature values at different positions on the negative electrode plate respectively on the basis of the lithium intercalation reaction rate ratios at different positions on the negative electrode plate and the test environment temperature

S104

determining an internal temperature distribution assessment result of the target battery cell on the basis of the temperature values at different positions on the negative electrode plate

Fig. 1

## Description

The present application claims the priority of the Chinese patent application filed to CNIPA on Dec. 8, 2021, with the application number of 202111491986.3 and the invention name of " method and apparatus for assessing internal temperature distribution of battery cell", the entire contents of which are incorporated herein by reference.

## Technical field

The present application relates to the technical field of lithium-ion batteries, in particular relates to a method and an apparatus for assessing internal temperature distribution of a battery cell, and an device and a storage medium.

## Technical background

Lithium-ion batteries have developed rapidly because of their excellent energy density and long cycle life, and have become a main development direction of energy storage equipment in the future. Due to frequent occurrence of lithium battery accidents such as fire and explosion, it is urgent to improve safety performance of lithium-ion batteries. Wherein, thermal runaway caused by a temperature change inside the lithium-ion battery is one of the main causes of battery accidents. When internal temperature of the lithium-ion battery is too high, a lot of side reactions (such as electrolyte decomposition and lithium dendrite growth) will occur in the lithium-ion battery, which will release a large amount of heat and trigger a chain reaction, leading to thermal runaway in the battery, thus causing accidents such as fire and explosion. Similarly, when the internal temperature of the battery is low, it will also lead to risks of battery performance degradation and lithium precipitation. It may be seen that, how to determine the internal temperature distribution of a battery is of great significance for improving the safety performance of the battery.

In the prior art, using an accelerating rate calorimeter is the most commonly used method to qualitatively or quantitatively monitor the temperature change of a battery cell. The most commonly used calorimeter is accelerating rate calorimeter (ARC), which measures the time-temperature-pressure data of chemical reaction under adiabatic conditions. When studying thermal characteristics of a battery, ARC may provide electrical characteristics of the battery before and after thermal runaway synchronously by monitoring voltage and resistance. However, this method is to analyze the thermal change of the whole battery pack, and the test environment is relatively harsh, which needs to be carried out in an adiabatic environment. Moreover, it cannot simulate the temperature change during the real use of a battery, and it cannot give the temperature gradient variation at different positions inside a battery cell.

## Summary of the invention

In view of this, the embodiments of the present application provide a method and an apparatus for assessing internal temperature distribution of a battery cell, so as to overcome the problem that the battery cell temperature monitoring method in the prior art cannot accurately master a change in an internal temperature gradient of the battery cell.

The embodiments of the present invention provide a method for assessing internal temperature distribution of a battery cell, which comprises the following steps:

acquiring lithium content at different positions on a negative electrode plate of a target battery cell and a corresponding test environment temperature;

determining lithium intercalation reaction rate ratios at different positions on the basis of the lithium content at different positions on the negative electrode plate;

calculating temperature values at different positions on the negative electrode plate respectively on the basis of the lithium intercalation reaction rate ratios at different positions on the negative electrode plate and the test environment temperature;

determining an internal temperature distribution assessment result of the target battery cell on the basis of the temperature values at different positions on the negative electrode plate.

Optionally, the step of acquiring lithium content at different positions on a negative electrode plate of a target battery cell comprises:

charging the target battery cell to a preset state of charge at the test environment temperature;

extracting a negative electrode plate of the target battery cell, and performing oxidation treatment on the negative electrode plate;

sampling at different positions on the oxidated negative electrode plate and weighing the samples for a first time;

after removing lithium ions from the samples corresponding to different positions, weighing the samples again for a second time;

determining the lithium content at different positions on the negative electrode plate on the basis of a difference between results of the two times of weighing the samples corresponding to different positions.

Optionally, the step of determining lithium intercalation reaction rate ratios at different positions on the basis of the lithium content at different positions on the negative electrode plate comprises:

calculating the lithium intercalation reaction rate ratios at different positions by the following formula:

$$K_A/K_E = M_A/M_E,$$

wherein, $K_A/K_E$ is a lithium intercalation reaction rate ratio of position A relative to position E, $K_A$ is a lithium intercalation reaction rate of position A, $K_E$ is a lithium intercalation reaction rate of position E, $M_A$ is lithium content of position A, and $M_E$ is lithium content of position E.

Optionally, the step of calculating temperature values at different positions on the negative electrode plate respectively on the basis of the lithium intercalation reaction rate ratios at different positions on the negative electrode plate and the test environment temperature comprises:
calculating temperature values at different positions on the negative electrode plate by the following formula:

$$ln\frac{K_x}{K_E} = \frac{E_a}{R}\frac{T_X - T_E}{T_X T_E},$$

wherein, $K_X/K_E$ is a lithium intercalation reaction rate ratio of a current position relative to position E, X is a serial number of the current position, R is a molar gas constant, Ea is a reaction activation energy of the target battery cell, $T_E$ is a temperature value of position E and a test environment temperature, $T_X$ is a temperature value of the current position, position E is an edge position on the negative electrode plate, and the temperature value corresponding to position E is the test environment temperature.
Optionally, the step of determining an internal temperature distribution assessment result of the target battery cell on the basis of the temperature values at different positions on the negative electrode plate comprises:
plotting a temperature gradient variation diagram from a center to an edge on the negative electrode plate on the basis of the temperature values at different positions on the negative electrode plate.
Optionally, the method further comprises:

acquiring temperature gradient variation diagrams corresponding to situations of charging the target battery cell to different preset states of charge at different test environment temperatures;
performing safety risk assessment on the target battery cell on the basis of the temperature gradient variation diagrams corresponding to situations of charging the target battery cell to different preset states of charge at different test environment temperatures to obtain a safety risk assessment result.

Optionally, the step of sampling at different positions on the oxidated negative electrode plate comprises:

removing part of the oxidated negative electrode plate outside an overlapping range of positive and negative electrode plates in both length and width directions;
sampling at different positions on the negative electrode plate after removing said part.

The embodiments of the present invention provide an apparatus for assessing internal temperature distribution of a battery cell, comprising:

an acquisition module, configured to acquire lithium content at different positions on a negative electrode plate of a target battery cell and a corresponding test environment temperature;

a first processing module, configured to determine lithium intercalation reaction rate ratios at different positions on the basis of the lithium content at different positions on the negative electrode plate;

a second processing module, configured to calculate temperature values at different positions on the negative electrode plate respectively on the basis of the lithium intercalation reaction rate ratios at different positions on the negative electrode plate and the test environment temperature;

a third processing module, configured to determine an internal temperature distribution assessment result of the target battery cell on the basis of the temperature values at different positions on the negative electrode plate.

The embodiments of the present application provide an electronic device, comprising a memory and a processor, wherein the memory and the processor are in communicational connection with each other, a computer program is stored in the memory, and the processor is configured to perform the method provided by the embodiments of the present application by executing the computer program.
The embodiments of the present application provide a computer-readable storage medium, wherein a computer program is stored in the computer-readable storage medium, and the computer program is configured to cause a computer to perform the method provided by the embodiments of the present application.

The technical scheme of this application has the follow advantages:

The embodiments of the present application provide a method and an apparatus for assessing internal temperature distribution of a battery cell, which comprises the following steps: acquiring lithium content at different positions on a negative electrode plate of a target battery cell and a corresponding test environment temperature; determining lithium intercalation reaction rate ratios at different positions on the basis of the lithium content at different positions on the negative electrode plate; calculating temperature values at different positions on the negative electrode plate respectively on the basis of the lithium intercalation reaction rate ratios at different positions on the negative electrode plate and the test environment temperature; determining an internal temperature distribution assessment result of the target battery cell on the basis of the temperature values at different positions on the negative electrode plate. Therefore, the reaction rate ratios at different positions on the negative electrode plate are calculated by measuring the lithium content on a lithium-intercalated negative electrode plate, and then the temperature gradients at different positions are calculated by the Arrhenius equation, and the internal temperature distribution assessment result of the battery cell is obtained. This method can be applied to most types of battery cells such as soft package, square shell, cylinder. The method has the advantages of a wide application range, a simple, accurate and efficient test and calculation way, so as to facilitate mastering a change in an internal temperature gradient of the battery cell, thereby providing accurate temperature parameters for battery cell designers, and providing a theoretical basis for improving the cyclic stability, safety and reliability of the battery cell.

**Brief description of appended drawings**

In order to explain the technical solutions in the specific embodiments of the present application or in the prior art more clearly, the appended drawings needed in the description of the specific embodiments or the prior art will be briefly introduced below. Apparently, the appended drawings described in the following description only represent some embodiments of the present application. For those skilled in this field, other drawings can be derived from these appended drawings without creative labor.

Fig. 1 is a flowchart of a method for assessing internal temperature distribution of a battery cell in an embodiment of the present application;

Fig. 2 is a schematic diagram of a sample preparation process in an embodiment of the present application;

Fig. 3 is a schematic diagram of internal temperature gradient variation of the battery cell in an embodiment of the present application;

Fig. 4 is a schematic structural diagram of an apparatus for assessing internal temperature distribution of a battery cell in an embodiment of the present application;

Fig. 5 is a schematic structural diagram of an electronic device in an embodiment of the present application;

Fig. 6 is a schematic structural diagram of a computer-readable storage medium in an embodiment of the present application.

**Detailed description**

In order to make the purpose, technical scheme and advantages of the embodiments of the present application clearer, the technical scheme in the embodiments of the present application will be described clearly and completely with reference to the appended drawings. Apparently, the described embodiments only represent part of the embodiments of the present application, not all of them. On the basis of the embodiments described in the present application, all other embodiments obtainable by those skilled in the art without creative labor belong to the protection scope of the present application.

The technical features involved in different embodiments of the present application described below may be combined with each other as long as they do not conflict with each other.

First of all, the technical terms mentioned in the embodiments of the present application are explained.

(1) SOC: State Of charge refers to a proportion of a current battery capacity of a battery, which is expressed as a ratio of the current battery capacity to the battery's maximum capacity, usually expressed as a percentage.

(2) Overhang area: an area in which a length and width of a negative electrode plate extends beyond that of a positive electrode plate.

(3) ICP: Inductively coupled plasma spectrometer, used to detect most elements in the periodic table.

(4) ARC: Accelerating rate calorimeter, a new-type thermal analysis instrument used for assessment of hazardous materials, which may provide time-temperature-pressure data of chemical reaction under adiabatic conditions.

Lithium-ion batteries have developed rapidly because of their excellent energy density and long cycle life, and have become a main development direction of energy storage equipment in the future. Due to frequent occurrence of lithium battery accidents such as fire and explosion, it is urgent to improve safety performance of lithium-ion batteries. Wherein, thermal runaway caused by a temperature change inside the lithium-ion battery is one of the main causes of battery accidents. When internal temperature of the lithium-ion battery is too high, a lot of side reactions (such as electrolyte decomposition and lithium dendrite growth) will occur in the lithium-ion battery, which will release a large amount of heat and trigger a chain reaction, leading to thermal runaway in the battery, thus causing accidents such as fire and explosion. Similarly, when the internal temperature of the battery is low, it will also lead to risks of battery performance degradation and lithium precipitation. It may be seen that, how to determine the internal temperature distribution of a battery is of great significance for improving the safety performance of the battery.

In the prior art, using an accelerating rate calorimeter is the most commonly used method to qualitatively or quantitatively monitor the temperature change of a battery cell. The most commonly used calorimeter is accelerating rate calorimeter (ARC), which measures the time-temperature-pressure data of chemical reaction under adiabatic conditions. When studying thermal characteristics of a battery, ARC may provide electrical characteristics of the battery before and after thermal runaway synchronously by monitoring voltage and resistance. However, this method is to analyze the thermal change of the whole battery pack, and the test environment is relatively harsh, which needs to be carried out in an adiabatic environment. Moreover, it cannot simulate the temperature change during the real use of a battery, and it cannot give the temperature gradient variation at different positions inside a battery cell.

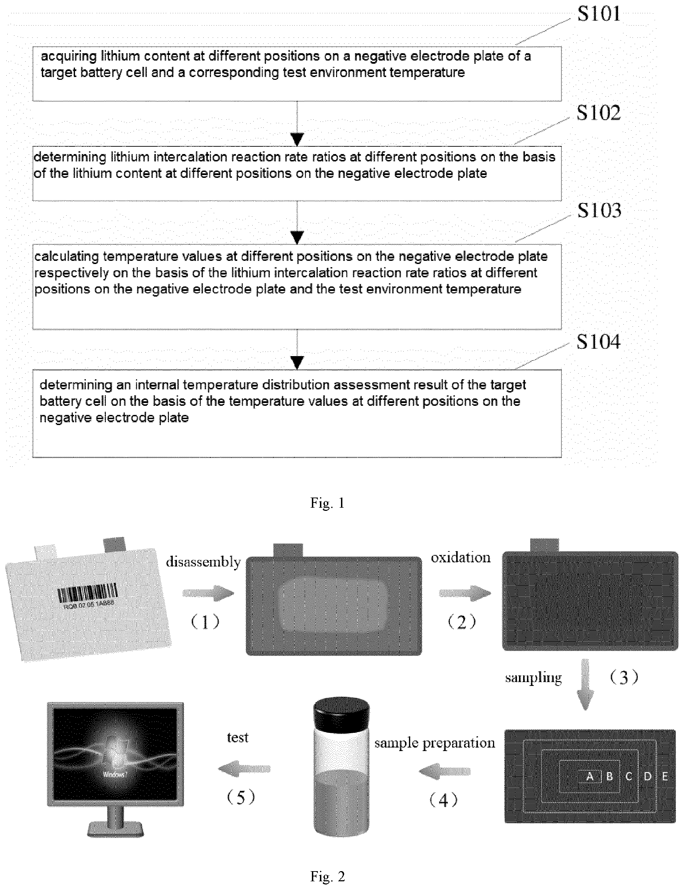

In consideration of the above problems, the embodiments of the present application provide a method for assessing internal temperature distribution of a battery cell, as shown in Fig. 1, which specifically comprises the following steps:

Step S101: acquiring lithium content at different positions on a negative electrode plate of a target battery cell and a corresponding test environment temperature.

Specifically, the present application uses a gradient difference of lithium intercalation content on the negative electrode plate to calculate a change in an internal temperature gradient of the battery cell. Within the same reaction time (for endothermic reaction), the greater a concentration of a product, the faster a reaction rate and the higher a reaction temperature. That is to say, for the same battery cell, when it is charged to a certain SOC state (reaction time is the same), if the lithium intercalation contents at different positions on the negative electrode plate inside the battery cell are different (the concentrations of the product are different), then the corresponding reaction rates are different. Therefore, the lithium content at different positions can be determined by charging the battery cell to a certain SOC state and then sampling the negative electrode plate of the battery cell, with the temperature of the test environment recorded.

Step S102: determining lithium intercalation reaction rate ratios at different positions on the basis of the lithium content at different positions on the negative electrode plate.

Specifically, the lithium intercalation reaction rate ratios at different positions are calculated by the following formula:

$$K_A/K_E = M_A/M_E,$$

wherein $K_A/K_E$ is a lithium intercalation reaction rate ratio of position A relative to position E, $K_A$ is a lithium intercalation reaction rate of position A, $K_E$ is a lithium intercalation reaction rate of position E, $M_A$ is lithium content of position A, and $M_E$ is lithium content of position E.

Step S103: calculating temperature values at different positions on the negative electrode plate respectively on the basis of the lithium intercalation reaction rate ratios at different positions on the negative electrode plate and the test environment temperature.

Specifically, the temperature values at different positions on the negative electrode plate are calculated by the following formula:

$$ln\frac{K_x}{K_E} = \frac{E_a}{R}\frac{T_x - T_E}{T_x T_E},$$

wherein, $K_X/K_E$ is a lithium intercalation reaction rate ratio of a current position relative to position E, X is a serial number of the current position, R is a molar gas constant, Ea is a reaction activation energy of the target battery cell, $T_E$ is a temperature value of position E and a test environment temperature, $T_X$ is a temperature value of the current position, position E is an edge position on the negative electrode plate, and the temperature value corresponding to position E is the test environment temperature.

Step S104: determining an internal temperature distribution assessment result of the target battery cell on the basis of the temperature values at different positions on the negative electrode plate.

Specifically, a temperature gradient variation diagram from a center to an edge on the negative electrode plate is plotted on the basis of the temperature values at different positions on the negative electrode plate. The temperature gradient variation diagram can accurately reflect the temperature distribution inside the battery cell, thus providing an accurate data basis for analyzing the stability of the battery cell.

By performing the above steps, the method for assessing the internal temperature distribution of the battery cell provided by the embodiments of the present application calculates the reaction rate ratios at different positions on the negative electrode plate by measuring the lithium content on a lithium-intercalated negative electrode plate, and then calculates the temperature gradient at different positions by using the Arrhenius equation, thereby obtaining the internal temperature distribution assessment result of the battery cell. This method can be applied to most types of battery cells such as soft package, square shell, cylinder. The method has the advantages of a wide application range, a simple, accurate and efficient test and calculation way, so as to facilitate mastering a change in an internal temperature gradient of the battery cell, thereby providing accurate temperature parameters for battery cell designers, and providing a theoretical basis for improving the cyclic stability, safety and reliability of the battery cell.

Specifically, in an embodiment, the above step S101 specifically comprises the following steps:

Step S201: charging the target battery cell to a preset state of charge at the test environment temperature.

Wherein, the preset state of charge may be flexibly set according to actual test requirements of the battery cell. For example, the preset state of charge is 50%SOC, but the present application is not limited to this.

Step S202: extracting a negative electrode plate of the target battery cell, and performing oxidation treatment on the negative electrode plate.

Specifically, the negative electrode plate may be taken out of a glove box or a drying room for oxidation, and the oxidation should be well ventilated to avoid generating a lot of smoke.

Step S203: sampling at different positions on the oxidated negative electrode plate and weighing the samples for a first time.

Specifically, part of the oxidated negative electrode plate outside an overlapping range of positive and negative electrode plates in both length and width directions is removed; sampling at different positions on the negative electrode plate is performed after removing said part.

For example, the battery cell may be divided into several regions from an edge to a center, and sampling points are selected in each region to sample the negative electrode plate. The more regions are divided, the more accurate a final temperature distribution result of the battery cell will be. A specific divided number of regions and basis thereof may be flexibly set according to the accuracy requirements of temperature distribution of the battery cell, and the present application is not limited to this.

Step S204: after removing lithium ions from the samples corresponding to different positions, weighing the samples again for a second time.

As an example, lithium ions may be removed by putting the samples into 10~100ml deionized water, respectively. Since the lithium in the lower layer beneath graphite can't be completely oxidized, a lot of hydrogen and smoke will be generated by a reaction between the charged negative electrode plate and water, so the operation must be performed in a fume cupboard. After active substances on the negative electrode plate samples fall off completely, carefully take out the copper foil, dry it and weigh it for a second time.

Step S205: determining the lithium content at different positions on the negative electrode plate on the basis of a difference between results of the two times of weighing the samples corresponding to different positions.

Specifically, according to a difference between the first weighing and the second weighing, the mass of the negative electrode active material dissolved in deionized water is calculated, and then the lithium content in the negative electrode active material of the sample is measured by using an inductively coupled plasma emission spectrometer (ICP).

Therefore, by testing the lithium content at different positions on the negative electrode plate, the lithium content at different positions on the negative electrode plate can be accurately obtained, so that the accuracy of the subsequent battery cell temperature distribution assessment result is guaranteed.

Specifically, in one embodiment, the method for assessing the internal temperature distribution of the battery cell further comprises the following steps:

Step S105: acquiring temperature gradient variation diagrams corresponding to situations of charging the target battery cell to different preset states of charge at different test environment temperatures.

Step S106: performing safety risk assessment on the target battery cell on the basis of the temperature gradient variation diagrams corresponding to situations of charging the target battery cell to different preset states of charge at different test environment temperatures to obtain a safety risk assessment result.

Specifically, because the temperature distribution of the battery cell is closely related to the SOC state of the battery cell as well as the environment temperature of the battery cell, therefore, by analyzing the temperature gradient variation diagrams of the battery cell under different temperature conditions and different SOC states, the safety risk assessment results obtained are also more comprehensive and objective, which can analyze the stability of the battery cell more comprehensively and accurately, thereby providing accurate data basis for optimization of the battery cell and prevention of safety risks.

Next, the method for assessing internal temperature distribution of a battery cell provided by the embodiments of the present application will be described in detail with reference to specific application examples.

A working principle of the embodiments of the present application is by using the gradient difference of lithium intercalation content on the negative electrode plate to calculate a change in an internal temperature gradient of the battery cell. Within the same reaction time (for endothermic reaction), the greater a concentration of a product, the faster a reaction rate and the higher a reaction temperature. That is to say, for the same battery cell, when it is charged to a certain SOC state (reaction time is the same), if the lithium intercalation contents at different positions on the negative electrode plate inside the battery are different (the concentrations of the product are different), then the corresponding reaction rates are different. So according to the Arrhenius equation:

$$K = Ae^{-\frac{E_a}{RT}}$$

, the reaction temperature at different positions can be deduced, and the change in the overall temperature gradient inside the battery cell can be obtained.

The embodiments of the present application specifically tests a lithium intercalation content gradient at different positions on the negative electrode plate by methods such as ICP so as to calculate a reaction rate gradient at different positions, and then calculates the temperature gradient at different positions according to the Arrhenius equation. An average temperature gradient distribution and an instantaneous temperature gradient distribution in the battery cell can be respectively calculated from 0%SOC to a certain SOC state and calculated between two adjacent SOC states, and the smaller the difference between adjacent SOC states, the denser the corresponding temperature gradient variation is. The experimental results show that different systems, different test environment temperatures, different charge-discharge rates, and different SOC states have great influences on the variation of the internal temperature gradient of the battery. Different systems have different SOC states that show a golden state (lithium intercalation state of $LiC_{12}$) in the middle; when the temperature of the test environment increases, the reaction rates at the edge and the middle accelerate at the same time, and it takes a larger temperature difference for the middle to show a golden state. With the increase of charge-discharge rate, the middle high temperature area becomes larger, so the middle golden area becomes larger; with the increase of SOC, the difference between the amount of lithium intercalation in the middle region and the amount of lithium intercalation in the edge region gradually increases, so a result of preferentially full intercalation in the middle is a superposition process. The specific implementation steps are as follows:

1. Lithium content test at different positions on the negative electrode plate (the sample preparation process is shown in Fig. 2):
Dismantle the battery cell that has been charged to a certain SOC (this SOC may be adjusted as needed) in a glove box or a drying room, and pay attention to separating the positive and negative electrode plates during disassembly to avoid accidents such as fire caused by short circuit; carefully take out the negative electrode plate from the glove box or drying room for oxidation, and pay attention to good ventilation during oxidation to avoid generating a lot of smoke; after removing an overhang area of the completely oxidized negative electrode plate, samples are taken as shown in step (3) of Fig. 2, which are respectively marked as A, B, C, D and E; weigh the samples for a first time, and record them as $M_{A1}$, $M_{B1}$, $M_{C1}$, $M_{D1}$ and $M_{E1}$ respectively; carefully put the five samples A, B, C, D and E into 10~100ml deionized water respectively. Since the lithium in the lower layer beneath graphite can't be completely oxidized, a lot of hydrogen and smoke will be generated by a reaction between the charged negative electrode plate and water, so the operation must be performed in a fume cupboard. After active substances on the negative electrode plate samples fall off completely, carefully take out the copper foil, dry it and weigh it for a second time, and record them as $M_{A2}$, $M_{B2}$, $M_{C2}$, $M_{D2}$ and $M_{E2}$ respectively; according to the difference between the first weighing and the second weighing ($M_{A0}=M_{A1}-M_{A2}$), the mass of the negative electrode active material dissolved in deionized water is calculated and recorded as $M_{A0}$, $M_{B0}$, $M_{C0}$, $M_{D0}$ and $M_{E0}$; by using methods such as ICP, the contents of lithium in the negative electrode active materials of the five samples of A, B, C, D and E are measured and recorded as $M_A$, $M_B$, $M_C$, $M_D$ and $M_E$.

2. Calculation of temperature gradient of the battery cell:
Because the battery is charged to a certain SOC within the same time, the ratio of lithium content at different positions on the electrode plate is the ratio of the corresponding lithium intercalation reaction rates; that is, the reaction rate ratios $K_A/K_E=M_A/M_E$, $K_B/K_E=M_B/M_E$, $K_C/K_E=M_C/M_E$, $K_D/K_E=M_D/M_E$; according to the Arrhenius equation:

$$K = Ae^{-\frac{E_a}{RT}}, \quad ln\frac{K_x}{K_E} = \frac{E_a}{R}\frac{T_x-T_E}{T_x T_E}$$

can be deduced, wherein X=A, B, C, D, and R is a molar gas constant, Ea is a reaction activation energy of the battery cell, which may be calculated by performing EIS test on the battery cell; furthermore,

$$\frac{T_x-T_E}{T_x T_E} = \frac{R}{E_a} ln\frac{K_x}{K_E}$$

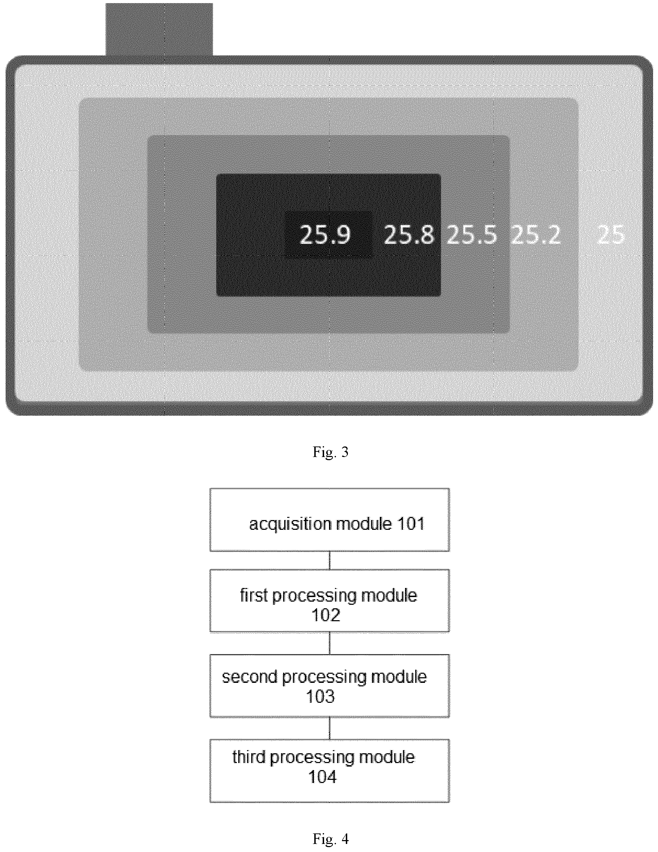

is deduced; because the edge of the battery cell dissipates heat quickly during the test, $T_E$ may be considered as the test environment temperature, so that $T_A$, $T_B$, $T_C$ and $T_D$ may be accurately calculated; finally, the temperature gradient variation diagram from the middle to the edge of the negative electrode plate is plotted, as shown in Fig. 3 (taking the test environment temperature being 25°C as an example), so as to infer the variation of the temperature gradient inside the whole battery cell.

The present application provides a method for rapidly and accurately assessing the temperature gradient variation inside a battery cell. This method can be applied to most types of the battery cells such as soft package, square shell, cylinder, and can also be used to measure the temperature variation at different positions inside the battery cell, which has the advantages of a wide application range, a simple, accurate and efficient test and calculation way, so as to facilitate mastering a change in an internal temperature gradient of the battery cell, thereby providing accurate temperature parameters for battery cell designers, and providing a theoretical basis for improving the cyclic stability, safety and reliability of the battery cell.

By performing the above steps, the method for assessing the internal temperature distribution of the battery cell provided by the embodiments of the present application calculates the reaction rate ratios at different positions on the negative electrode plate by measuring the lithium content on a lithium-intercalated negative electrode plate, and then calculates the temperature gradient at different positions by using the Arrhenius equation, thereby obtaining the internal temperature distribution assessment result of the battery cell. This method can be applied to most types of battery cells such as soft package, square shell, cylinder. The method has the advantages of a wide application range, a simple, accurate and efficient test and calculation way, so as to facilitate mastering a change in an internal temperature gradient of the battery cell, thereby providing accurate temperature parameters for battery cell designers, and providing a theoretical basis for improving the cyclic stability, safety and reliability of the battery cell.

The embodiments of the present application also provide an apparatus for assessing the internal temperature distribution of the battery cell, as shown in Fig. 4, and the apparatus for assessing the internal temperature distribution of the battery cell comprises:
An acquisition module 101, configured to acquire lithium content at different positions on a negative electrode plate of a target battery cell and a corresponding test environment temperature. For details, please refer to the related description of step S101 in the above method embodiment, which will not be repeated here.

A first processing module 102, configured to determine lithium intercalation reaction rate ratios at different positions on the basis of the lithium content at different positions on the negative electrode plate. For details, please refer to the related description of step S102 in the above-mentioned method embodiment, which will not be repeated here.

A second processing module 103, configured to calculate temperature values at different positions on the negative electrode plate respectively on the basis of the lithium intercalation reaction rate ratios at different positions on the negative electrode plate and the test environment temperature. For details, please refer to the related description of step S103 in the above method embodiment, which will not be repeated here.

A third processing module 104, configured to determine an internal temperature distribution assessment result of the target battery cell on the basis of the temperature values at different positions on the negative electrode plate. For details, please refer to the related description of step S104 in the above method embodiment, which will not be repeated here.

By means of the cooperation of the above components, the apparatus for assessing the internal temperature distribution of the battery cell provided by the embodiments of the present application calculates the reaction rate ratios at different positions on the negative electrode plate by measuring the lithium content on a lithium-intercalated negative electrode plate, and then calculates the temperature gradient at different positions by using the Arrhenius equation, thereby obtaining the internal temperature distribution assessment result of the battery cell. This method can be applied to most types of battery cells such as soft package, square shell, cylinder. The method has the advantages of a wide application range, a simple, accurate and efficient test and calculation way, so as to facilitate mastering a change in an internal temperature gradient of the battery cell, thereby providing accurate temperature parameters for battery cell designers, and providing a theoretical basis for improving the cyclic stability, safety and reliability of the battery cell.

Further functional descriptions of the above-mentioned modules are the same as those of the above-mentioned corresponding method embodiments, and will not be repeated here.

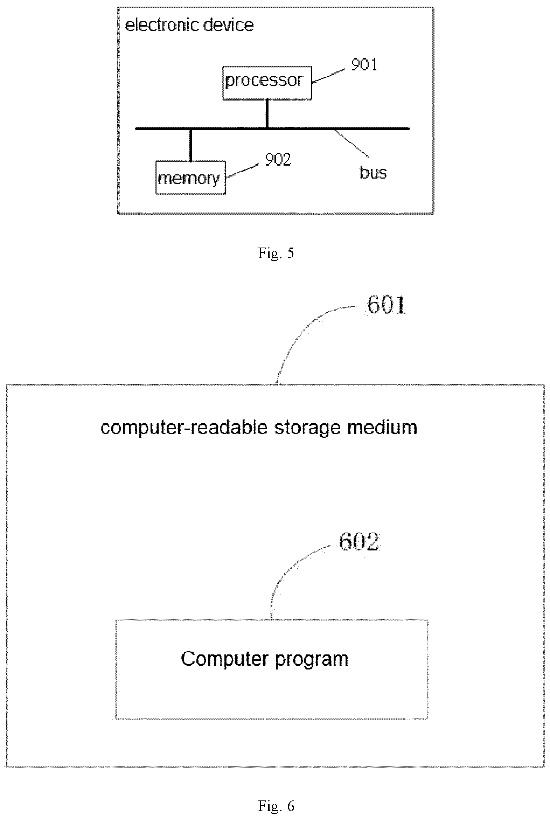

According to the embodiments of the present application, an electronic device is also provided. As shown in Fig. 5, the electronic device may comprise a processor 901 and a memory 902, wherein the processor 901 and the memory 902 may be connected by a bus or other means. In Fig. 5, the connection by a bus is taken as an example.

The processor 901 may be a Central Processing Unit (CPU). The processor 901 may also be other general-purpose processors, Digital Signal Processor (DSP), application specific integrated circuits (ASIC), Field-Programmable Gate Array (FPGA) or other programmable logic devices, discrete gates or transistor logic devices, discrete hardware components and other chips, or a combination of the above-mentioned chips.

As a non-transitory computer-readable storage medium, the memory 902 may be used to store non-transitory software programs, non-transitory computer-executable programs and modules, such as program instructions/modules corresponding to the method in the method embodiments of the present application. The processor 901 executes various functional applications and data processing of the processor by running non-transitory software programs, instructions and modules stored in the memory 902, that is, the method in the above method embodiments can be realized.

The memory 902 may comprise a program storage area and a data storage area, wherein the program storage area may store an application program required for operating at least one function of the device; the data storage area may store data created by the processor 901 and the like. In addition, the memory 902 may comprise high-speed random access memory and non-transitory memory, such as at least one disk memory device, flash memory device, or other non-transitory solid-state memory devices. In some embodiments, the memory 902 may optionally comprise memories located remotely from the processor 901, and these remote memories may be connected to the processor 901 through a network. Examples of the above network comprise, but are not limited to, the Internet, an intranet, a local area network, a mobile communication network, and combinations thereof.

One or more modules are stored in the memory 902, and when the one or more modules are executed by the processor 901, the method in the above method embodiments is performed.

The specific details of the above-mentioned electronic device may be understood by referring to the corresponding related descriptions and effects in the above-mentioned method embodiments, and will not be repeated here.

Fig. 6 is a schematic structural diagram of a computer-readable storage medium in an embodiment of the present application. As shown in Fig. 6, those skilled in the art can understand that all or part of the processes in the methods of the above embodiments may be completed by a computer program 602 instructing related hardware, the computer program 602 may be stored in the computer-readable storage medium 601, and when executed, the computer program 602 may comprise the processes of the above method embodiments. The storage medium 601 may be a magnetic disk, an optical disk, a Read-Only Memory (ROM), a Random Access Memory (RAM), a Flash Memory, a Hard Disk Drive (HDD) or a Solid-State Drive (SSD). The storage medium may also comprise a combination of the above kinds of memories.

Although the embodiments of the present application have been described with reference to the appended drawings, those skilled in the art may make various modifications and variations without departing from the spirit and scope of the present application, and such modifications and variations are all within the scope defined by the appended claims.

**Claims**

1. A method for assessing internal temperature distribution of a battery cell, comprising:

   acquiring lithium content at different positions on a negative electrode plate of a target battery cell and a corresponding test environment temperature;
   determining lithium intercalation reaction rate ratios at different positions on the basis of the lithium content at different positions on the negative electrode plate;
   calculating temperature values at different positions on the negative electrode plate respectively on the basis of the lithium intercalation reaction rate ratios at different positions on the negative electrode plate and the test environment temperature;
   determining an internal temperature distribution assessment result of the target battery cell on the basis of the temperature values at different positions on the negative electrode plate.

2. The method according to claim 1, wherein the step of acquiring lithium content at different positions on a negative electrode plate of a target battery cell comprises:

   charging the target battery cell to a preset state of charge at the test environment temperature;
   extracting a negative electrode plate of the target battery cell, and performing oxidation treatment on the negative electrode plate;
   sampling at different positions on the oxidated negative electrode plate and weighing the samples for a first time;
   after removing lithium ions from the samples corresponding to different positions, weighing the samples again for a second time;
   determining the lithium content at different positions on the negative electrode plate on the basis of a difference between results of the two times of weighing the samples corresponding to different positions.

3. The method according to claim 1, wherein the step of determining lithium intercalation reaction rate ratios at different positions on the basis of the lithium content at different positions on the negative electrode plate comprises:

   calculating the lithium intercalation reaction rate ratios at different positions by the following formula:

   $$K_A/K_E = M_A/M_E,$$

   wherein, $K_A/K_E$ is a lithium intercalation reaction rate ratio of position A relative to position E, $K_A$

is a lithium intercalation reaction rate of position A, $K_E$ is a lithium intercalation reaction rate of position E, $M_A$ is lithium content of position A, and $M_E$ is lithium content of position E.

4. The method according to claim 3, wherein the step of calculating temperature values at different positions on the negative electrode plate respectively on the basis of the lithium intercalation reaction rate ratios at different positions on the negative electrode plate and the test environment temperature comprises:

calculating temperature values at different positions on the negative electrode plate by the following formula:

$$ln\frac{K_x}{K_E} = \frac{E_a}{R}\frac{T_x - T_E}{T_x T_E},$$

wherein, $K_X/K_E$ is a lithium intercalation reaction rate ratio of a current position relative to position E, X is a serial number of the current position, R is a molar gas constant, Ea is a reaction activation energy of the target battery cell, $T_E$ is a temperature value of position E and a test environment temperature, $T_X$ is a temperature value of the current position, position E is an edge position on the negative electrode plate, and the temperature value corresponding to position E is the test environment temperature.

5. The method according to claim 1, wherein the step of determining an internal temperature distribution assessment result of the target battery cell on the basis of the temperature values at different positions on the negative electrode plate comprises:
plotting a temperature gradient variation diagram from a center to an edge on the negative electrode plate on the basis of the temperature values at different positions on the negative electrode plate.

6. The method according to claim 2, further comprising:

acquiring temperature gradient variation diagrams corresponding to situations of charging the target battery cell to different preset states of charge at different test environment temperatures;
performing safety risk assessment on the target battery cell on the basis of the temperature gradient variation diagrams corresponding to situations of charging the target battery cell to different preset states of charge at different test environment temperatures to obtain a safety risk assessment result.

7. The method according to claim 2, wherein the step of sampling at different positions on the oxidated negative electrode plate comprises:

removing part of the oxidated negative electrode plate outside an overlapping range of positive and negative electrode plates in both length and width directions;
sampling at different positions on the negative electrode plate after removing said part.

8. An apparatus for assessing internal temperature distribution of a battery cell, comprising:

an acquisition module, configured to acquire lithium content at different positions on a negative electrode plate of a target battery cell and a corresponding test environment temperature;
a first processing module, configured to determine lithium intercalation reaction rate ratios at different positions on the basis of the lithium content at different positions on the negative electrode plate;
a second processing module, configured to calculate temperature values at different positions on the negative electrode plate respectively on the basis of the lithium intercalation reaction rate ratios at different positions on the negative electrode plate and the test environment temperature;
a third processing module, configured to determine an internal temperature distribution assessment result of the target battery cell on the basis of the temperature values at different positions on the negative electrode plate.

9. An electronic device, comprising:
a memory and a processor, wherein the memory and the processor are in communicational connection with each other, a computer program is stored in the memory, and the processor is configured to perform the method according to any one of claims 1 to 7 by executing the computer program.

10. A computer-readable storage medium, wherein a computer program is stored in the computer-readable storage medium, and the computer program is configured to cause a computer to perform the method according to any one of claims 1 to 7.

acquiring lithium content at different positions on a negative electrode plate of a target battery cell and a corresponding test environment temperature

S101

determining lithium intercalation reaction rate ratios at different positions on the basis of the lithium content at different positions on the negative electrode plate

S102

calculating temperature values at different positions on the negative electrode plate respectively on the basis of the lithium intercalation reaction rate ratios at different positions on the negative electrode plate and the test environment temperature

S103

determining an internal temperature distribution assessment result of the target battery cell on the basis of the temperature values at different positions on the negative electrode plate

S104

Fig. 1

disassembly (1)

oxidation (2)

sampling (3)

A B C D E

sample preparation (4)

test (5)

Fig. 2

Fig. 3

Fig. 4

electronic device

processor — 901

memory — 902

bus

Fig. 5

— 601

computer-readable storage medium

— 602

Computer program

Fig. 6

**EP 4 394 406 A1**

## INTERNATIONAL SEARCH REPORT

International application No.

**PCT/CN2022/085270**

| A. | CLASSIFICATION OF SUBJECT MATTER |
|---|---|

G01R 31/382(2019.01)i

According to International Patent Classification (IPC) or to both national classification and IPC

| B. | FIELDS SEARCHED |
|---|---|

Minimum documentation searched (classification system followed by classification symbols)

G01R 31/-

Documentation searched other than minimum documentation to the extent that such documents are included in the fields searched

Electronic data base consulted during the international search (name of data base and, where practicable, search terms used)

CNPAT, WPI, EPODOC, CNKI: 蜂巢能源科技(无锡)有限公司, 王娇娇, 于奥, 李树贤, 张耍军, 何见超, 高飞, 杨红新, 电池, 电芯, 内部, 温度, 分布, 评估, 估算, 嵌锂, 锂含量, 反应, 速度, 速率, 负极, 不同, battery, cell, temperature, evaluat+, distributi on, lithium, Li, negative, different, reaction, rate

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 114184964 A (HONEYCOMB ENERGY TECHNOLOGY (TIN-FREE) LTD., CO.) 15 March 2022 (2022-03-15) description, paragraphs [0004]-[0040], and figures 1-11 | 1-10 |
| A | CN 112578298 A (BYD CO., LTD.) 30 March 2021 (2021-03-30) description, paragraphs [0029]-[0094], and figures 1-11 | 1-10 |
| A | CN 111208431 A (TIANJIN EV ENERGIES CO., LTD.) 29 May 2020 (2020-05-29) entire document | 1-10 |
| A | CN 110457742 A (BEIHANG UNIVERSITY) 15 November 2019 (2019-11-15) entire document | 1-10 |
| A | CN 112162200 A (HEFEI GUOXUAN HIGH-TECH POWER ENERGY CO., LTD.) 01 January 2021 (2021-01-01) entire document | 1-10 |
| A | CN 111475933 A (NO.18 RESEARCH INSTITUTE OF CETC) 31 July 2020 (2020-07-31) entire document | 1-10 |

☑ Further documents are listed in the continuation of Box C.     ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **11 July 2022** | **28 July 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

15

## INTERNATIONAL SEARCH REPORT

| International application No. |
| --- |
| **PCT/CN2022/085270** |

### C. DOCUMENTS CONSIDERED TO BE RELEVANT

| Category* | Citation of document, with indication, where appropriate, of the relevant passages | Relevant to claim No. |
| --- | --- | --- |
| A | CN 105206888 A (ZHIJIANG COLLEGE OF ZHEJIANG UNIVERSITY OF TECHNOLOGY) 30 December 2015 (2015-12-30)<br>    entire document | 1-10 |
| A | CN 109872002 A (TANG YIWEI) 11 June 2019 (2019-06-11)<br>    entire document | 1-10 |
| A | CN 113093029 A (TIANJIN LISHEN BATTERY JOINT-STOCK CO., LTD.) 09 July 2021 (2021-07-09)<br>    entire document | 1-10 |
| A | JP 2006010648 A (MITSUBISHI CHEMICAL CORP.) 12 January 2006 (2006-01-12)<br>    entire document | 1-10 |

Form PCT/ISA/210 (second sheet) (January 2015)

INTERNATIONAL SEARCH REPORT
Information on patent family members

International application No.

**PCT/CN2022/085270**

| Patent document cited in search report | | | Publication date (day/month/year) | Patent family member(s) | | | Publication date (day/month/year) |
|---|---|---|---|---|---|---|---|
| CN | 114184964 | A | 15 March 2022 | None | | | |
| CN | 112578298 | A | 30 March 2021 | CN | 112578298 | B | 15 March 2022 |
| | | | | WO | 2021057917 | A1 | 01 April 2021 |
| CN | 111208431 | A | 29 May 2020 | None | | | |
| CN | 110457742 | A | 15 November 2019 | None | | | |
| CN | 112162200 | A | 01 January 2021 | None | | | |
| CN | 111475933 | A | 31 July 2020 | None | | | |
| CN | 105206888 | A | 30 December 2015 | CN | 105206888 | B | 06 April 2018 |
| CN | 109872002 | A | 11 June 2019 | None | | | |
| CN | 113093029 | A | 09 July 2021 | None | | | |
| JP | 2006010648 | A | 12 January 2006 | JP | 4576903 | B2 | 10 November 2010 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111491986